# EUROPEAN PATENT APPLICATION

(11) **EP 2 966 124 A1**
(43) Date of publication of application: **13.01.2016**
(21) Application number: 14176399.5
(22) Date of filing: 09.07.2014
(51) Int. Cl.: C08L 67/00, H01B 1/22, H01L 31/0224, H01L 31/18, C08K 3/08

(54) **Electro-conductive paste with characteristic weight loss for low temperature application**

(71) Applicant: Heraeus Deutschland GmbH & Co. KG, 63450 Hanau (DE)
(72) Inventor: Muschelknautz, Christian, 64291 Darmstadt (DE); Hörteis, Matthias, 63454 Hanau (DE)
(74) Representative: Herzog, Fiesser & Partner Patentanwälte PartG mbB

(57) **Abstract**

In general, the invention relates to electro-conductive pastes with characteristic weight loss and their use in the preparation of photovoltaic solar cells. More specifically, the invention relates to electro-conductive pastes, solar cell precursors, processes for preparation of solar cells, solar cells and solar modules.
1. The invention relates to paste comprising the following paste constituents:
a. Metal particles;
b. A polymer system;
wherein the first weight loss Δ₃₀, determined according to the test method provided herein, is in the range from about 0.02 to about 0.5.

## Description

### FIELD OF THE INVENTION

In general, the invention relates to electro-conductive pastes with characteristic weight loss and their use in the preparation of electrodes, particularly in electrical devices, particularly in temperature sensitive electrical devices or solar cells, particularly in HIT (Heterojunction with Intrinsic Thin-layer) solar cells. More specifically, the invention relates to electro-conductive pastes, solar cell precursors, processes for preparation of solar cells, solar cells and solar modules.

### BACKGROUND OF THE INVENTION

Electrodes are an essential part of a wide range of economically important electrical devices, such as solar cells, display screens, electronic circuitry, or parts thereof. One particularly important such electrical device is the solar cell.

Solar cells are devices that convert the energy of light into electricity using the photovoltaic effect. Solar power is an attractive green energy source because it is sustainable and produces only non-polluting by-products. Accordingly, a great deal of research is currently being devoted to developing solar cells with enhanced efficiency while continuously lowering material and manufacturing costs. When light hits a solar cell, a fraction of the incident light is reflected by the surface and the remainder transmitted into the solar cell. The transmitted photons are absorbed by the solar cell, which is usually made of a semiconducting material, such as silicon which is often doped appropriately. The absorbed photon energy excites electrons of the semiconducting material, generating electron-hole pairs. These electron-hole pairs are then separated by p-n junctions and collected by conductive electrodes on the solar cell surfaces.

Solar cells are very commonly based on silicon, often in the form of a Si wafer. Here, a p-n junction is commonly prepared either by providing an n-type doped Si substrate and applying a p-type doped layer to one face or by providing a p-type doped Si substrate and applying an n-type doped layer to one face to give in both cases a so called p-n junction. The face with the applied layer of dopant generally acts as the front face of the cell, the opposite side of the Si with the original dopant acting as the back face. Both n-type and p-type solar cells are possible and have been exploited industrially. Cells designed to harness light incident on both faces are also possible, but their use has been less extensively harnessed.

In order to allow incident light on the front face of the solar cell to enter and be absorbed, the front electrode is commonly arranged in two sets of perpendicular lines known as "fingers" and "bus bars" respectively. The fingers form an electrical contact with the front face and bus bars link these fingers to allow charge to be drawn off effectively to the external circuit. It is common for this arrangement of fingers and bus bars to be applied in the form of an electro-conductive paste which is fired to give solid electrode bodies. A back electrode is also often applied in the form of an electro-conductive paste which is then fired to give a solid electrode body.

Another approach to solar cell preparation seeks to provide advantageous cell properties by including amorphous silicon layers. Also known as HIT (Heterojunction with Intrinsic Thin layer) solar cells, such cells can allow reduction of negative effects associated with electron-hole recombination. The amorphous regions in such HIT cells are often temperature sensitive. For further details on HIT-type cells and further applications of low temperature curing pastes used for temperature sensitive devices, please see US 2013/0142963 A1, which is hereby incorporated into this application in its entirety.

There is a need in the state of the art for improved methods for the application of electrodes to substrates, particularly if the substrate is temperature sensitive, as is often the case for HIT solar cells.

### SUMMARY OF THE INVENTION

The invention is generally based on the object of overcoming at least one of the problems encountered in the state of the art in relation to electrodes, in particular in relation to electrodes in solar cells or temperature sensitive devices, in particular HIT solar cells.

More specifically, the invention is further based on the object of improving the effective printing period of the paste, preferably whilst maintaining good performance of the solar cell, preferably maintaining a good short circuit current density J_{sc}.

One object of the invention is to improve flooding of the paste on the screen and hence the period during which the screen can be used for printing before cleaning. The need for cleaning can be observed through the occurrence of dry zones on the screen and can result in interruptions in the electrode and consequent impairment of cell performance. One object is to improve flooding and/or printing time whilst maintaining a high aspect ratio of the printed fingers.

A further object of the invention is to provide processes for preparing solar cells.

A contribution to achieving at least one of the above described objects is made by the subject matter of the category forming claims of the invention. A further contribution is made by the subject matter of the dependent claims of the invention which represent specific embodiments of the invention.

### DETAILED DESCRIPTION

A contribution to achieving at least one of the above described objects is made by the following embodiments:
|1| A paste comprising the following paste constituents:
   i. Metal particles;
   ii. A polymer system;
   wherein the first weight loss Δ₃₀, determined according to the test method provided herein, is in the range from about 0.02 to about 0.5, preferably in the range from about 0.03 to about 0.2, more preferably in the range from about 0.05 to about 0.1.
|2| The paste according to embodiment |1|, wherein the second weight loss Δ_{low 30}, determined according to the test method provided herein, is in the range from about 0.001 to about 0.1, preferably in the range from about 0.002 to about 0.05, more preferably in the range from about 0.003 to about 0.02.
|3| The paste according to any of the preceding embodiments, wherein the third weight loss Δ_{high 30}, determined according to the test method provided herein, is in the range from about 0.3 to about 1.0, preferably in the range from about 0.8 to about 1.0, more preferably in the range from about 0.9 to about 1.0.
|4| The paste according to any of the preceding embodiments, wherein the metallic particles are silver.
|5| The paste according to any of the preceding embodiments, wherein the metallic particles are at least about 70 wt. %, preferably at least about 80 wt. %, more preferably at least about 85 wt. %, based on the total weight of the paste.
|6| The paste according to any of the preceding embodiments, wherein the viscosity of the paste is in the range from about 5 to about 25 Pa•s, preferably in the range from about 7 to about 20 Pa•s, more preferably in the range from about 10 to about 18 Pa•s.
|7| The paste according to any of the embodiments, wherein the polymer system is a thermoplastic polymer system, wherein the thermoplastic polymer system comprises a thermoplastic polymer.
|8| The paste according to embodiment |7|, wherein the thermoplastic polymer shows at least one of the following parameters:
   i. a glass transition temperature in the range from about -120 to about 110 °C, preferably in the range from about 0 to about 100 °C, more preferably in the range from about 20 to about 80 °C;
   ii. a melting temperature being at least about 5°C higher, preferably at least about 10 °C higher, more preferably at least about 15 °C higher, than the glass transition
      temperature; or
   iii. a number average molecular weight in the range from about 10,000 to about 150,000 g/mol, preferably in the range from about 10,000 to about 100,000 g/mol, more preferably in the range from about 11,000 to about 80,000 g/mol.
|9| The paste according to embodiments |7| or |8|, wherein the thermoplastic polymer is present in the thermoplastic polymer system in an amount in the range from about 5 to about 45 wt. %, preferably in the range from about 10 to about 40 wt. %, more preferably in the range from about 15 to about 35 wt. %, based on the total weight of the thermoplastic polymer system.
|10| The paste according to any of the embodiments |7| to |9|, wherein the thermoplastic polymer is selected from the group consisting of a polyester, an acrylate polymer, a phenoxy polymer.
|11| The paste according to any of the embodiments |7| to |10|, wherein the thermoplastic polymer comprises a polyester backbone.
|12| The paste according to any of the preceding embodiments, wherein the polymer system comprises a solvent system.
|13| The paste according to embodiment |12|, wherein the solvent system is present in the thermoplastic polymer system in an amount of at least 50 wt. %, preferably in an amount of at least 55 wt. %, more preferably in an amount of at least 60 wt. %, based on the total weight of the thermoplastic polymer system.
|14| The paste according to any of the embodiments |12| to |13|, wherein the solvent system is present in the paste in an amount in the range from about 0.1 to 20 wt. %, preferably in the range from about 1 to about 18 wt. %, more preferably in the range from about 2 to about 15 wt. %, based on the total weight of the paste.
|15| A precursor comprising the following precursor components:
   a. a substrate;
   b. a paste according to any of the preceding embodiment superimposed on the substrate.
|16| A precursor according to embodiment |15|, wherein the substrate is temperature sensitive.
|17| A precursor according to embodiment |15| or |16|, wherein the substrate is a silicon wafer.
|18| A precursor according to any of embodiments |15| to |17|, wherein the substrate comprises a p-n junction.
|19| The precursor according to any of the embodiments |15| to |18|, wherein the wafer comprises a first silicon layer, wherein less than 50 wt. %, preferably less than 20 wt. %, more preferably less than 10 wt. %, of the first silicon layer is crystalline.
|20| The precursor according to any of the embodiments 1151 to |19|, wherein the wafer comprises a further silicon layer, wherein at least about 50 wt. %, preferably at least about 70 wt. %, more preferably at least about 90 wt. %, of the further silicon layer is crystalline.
|21| The precursor according to any of the embodiments 1151 to |20|, wherein the substrate comprises a transparent conductive layer
|22| The precursor according to embodiment |21|, wherein the transparent conductive layer is selected from the group consisting of the following: a conductive polymer, a conductive oxide.
|23| A process for the preparation of an electrical or electronic component comprising the following preparation steps:
   i. providing a precursor according to any of the embodiments |15| to |22|;
   ii. heating the precursor to obtain the component.
|24| The process according to embodiment |23|, wherein the component is a solar cell.
|25| The process according to embodiment |23| or |24|, wherein the maximum firing temperature in step ii is in the range from about 50 to about 300 °C, preferably in the range from about 80 to about 280 °C, more preferably in the range from about 100 to about 250 °C.
|26| The process according to any of the embodiments |23| to |25|, wherein the temperature is above 50 °C for not more than 30 min, preferably not more than 20 min, more preferably not more than about 15 min, during the heating step.
|27| The process according to any of the embodiments |23| to |26|, wherein the paste is applied to the front side of the wafer.
|28| The process according to of the embodiments |23| to |27|, wherein the paste is applied through a screen.
|29| The process according to any of the embodiments |23| to |28|, wherein the paste is applied as lines with a width in the range from about 20 to about 100 µm, preferably in the range from about 30 to about 90 µm, more preferably in the range from about 40 to about 80 µm.
|30| A solar cell obtainable by the process according to any of the embodiments |23| to |29|.
|31| The solar cell according to embodiment |30| comprising electrodes with a width in the range from about 20 to about 100 µm, preferably in the range from about 30 to about 90 µm, more preferably in the range from about 40 to about 80 µm.
|32| The solar cell according to embodiment |30| or |31| comprising electrodes with an aspect ratio in the range from about 0.1 to about 1, preferably in the range from about 0.1 to about 0.5, more preferably in the range from about 0.1 to about 0.2.
|33| A module comprising at least 2 solar cells, at least 1 of which is according to one of the embodiments |30| to |32|.

The above embodiments can be combined amongst each other. Each possible combination is herewith a part of the disclosure of the specification.

### Substrate

Preferred substrates according to the invention are solid articles to which at least one electrode is applied by a process according to the invention. Substrates are well known to the skilled person and he may choose the substrate as appropriate to suit one of a number of applications. The substrate is preferably chosen in order to improve the electrical and/or physical properties of the electrode-substrate contact as necessary for the particular application.

The substrate may comprise a single material or two or more regions of different materials. Preferred substrates which comprise two or more regions of different materials are layer bodies and/or coated bodies.

Preferred substrate materials are semiconductors; organic materials, preferably polymers; inorganic materials, preferably oxides or glasses; metal layers. The substrate material, or materials, may be insulators, preferably glass, polymers or ceramic; semiconductors, preferably a doped group IV or group III/V element/binary compound, or an organic semiconductor; or conductors, preferably a metallised surface or conductive polymer surface; depending on the intended use of the obtained device. The preferred substrates in the context of this invention are wafers, preferably silicon wafers, preferably for the preparation of a solar cell as described in continuation:

For further substrate type which are application in the context of the invention, please refer to US 2013/0142963 A1. Some preferred electrical devices in the context of the invention are RFID (radio frequency identification) devices; photovoltaic devices, in particular solar cells; light-emissive devices, for example, displays, LEDs (light emitting diodes), OLEDs (organic light emitting diodes); smart packaging devices; and touchscreen devices.

In one embodiment, the substrate is temperature sensitive, preferably a substrate which is impaired at a temperature above about 500 °C, preferably above 400 °C, more preferably above about 300 °C.

Preferred wafers according to the invention are regions, among other regions of the solar cell, capable of absorbing light with high efficiency to yield electron-hole pairs and separating holes and electrons across a boundary with high efficiency, preferably across a so called p-n junction boundary.

It is preferred for the wafer to consist of appropriately doped tetravalent elements, binary compounds, tertiary compounds or alloys. Preferred tetravalent elements in this context are Si, Ge or Sn, preferably Si. Preferred binary compounds are combinations of two or more tetravalent elements, binary compounds of a group III element with a group V element, binary compounds of a group II element with a group VI element or binary compounds of a group IV element with a group VI element. Preferred combinations of tetravalent elements are combinations of two or more elements selected from Si, Ge, Sn or C, preferably SiC. The preferred binary compounds of a group III element with a group V element is GaAs. It is most preferred according to the invention for the wafer to be based on Si. Si, as the most preferred material for the wafer, is referred to explicitly throughout the rest of this application. Sections of the following text in which Si is explicitly mentioned also apply for the other wafer compositions described above.

It is preferred according to the invention for the solar cell to comprise at least one n-type doped layer and at least one p-type doped layer in order to provide a p-n junction boundary.

Doped Si substrates are well known to the person skilled in the art. The doped Si substrate can be prepared in any way known to the person skilled in the art and which he considers to be suitable in the context of the invention. Preferred sources of Si substrates according to the invention are mono-crystalline Si, multi-crystalline Si, amorphous Si and upgraded metallurgical Si, mono-crystalline Si or multi-crystalline Si being most preferred. Doping to form the doped Si substrate can be carried out simultaneously by adding dopant during the preparation of the Si substrate or can be carried out in a subsequent step. Doping subsequent to the preparation of the Si substrate can be carried out for example by gas diffusion epitaxy. Doped Si substrates are also readily commercially available. According to the invention it is one option for the initial doping of the Si substrate to be carried out simultaneously to its formation by adding dopant to the Si mix. According to the invention it is one option for the application of the front doped layer and the highly doped back layer, if present, to be carried out by gas-phase epitaxy. This gas phase epitaxy is preferably carried out at a temperature in a range from about 500 °C to about 900 °C, more preferably in a range from about 600 °C to about 800 °C and most preferably in a range from about 650 °C to about 750 °C at a pressure in a range from about 2 kPa to about 100 kPa, preferably in a range from about 10 to about 80 kPa, most preferably in a range from about 30 to about 70 kPa. These temperature conditions usually do not apply to HIT solar cells.

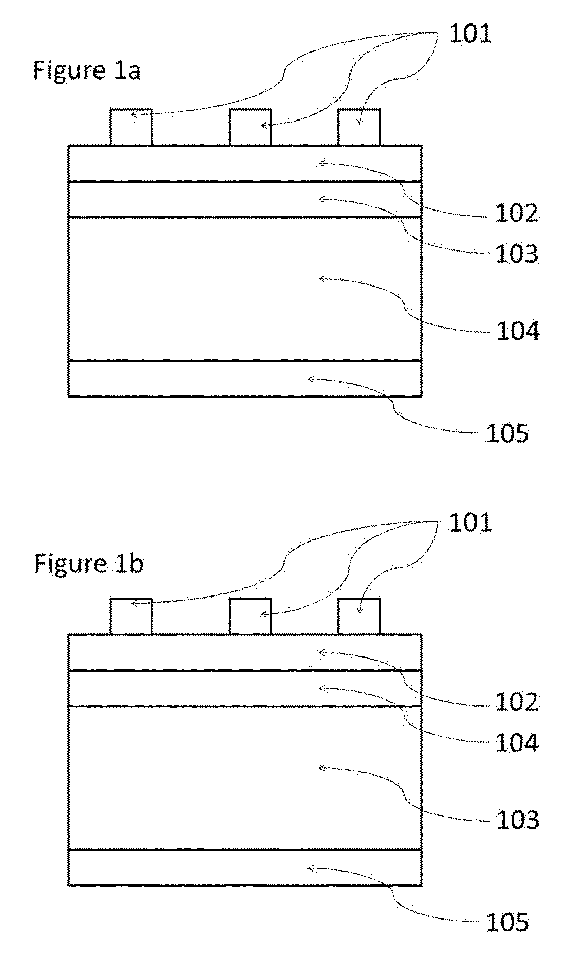

In one embodiment of the invention, the wafer comprises an n-type doped layer and a p-type doped layer and can be used to prepare what is known as an n-type cell (Figure 1a) or a p-type cell (Figure 1b).

In another embodiment of the invention, the wafer comprises one or more amorphous layers. Amorphous layers and intrinsic layers (non-doped layers) are preferably employed in order to reduce the frequency of electron-hole re-combinations and thus improve the electrical properties of the cell. It is preferred for the wafer to comprise at least one, preferably at least two, preferably two, non-doped amorphous layers. It is preferred for the wafer to comprise at least one, preferably at least two, preferably two, doped amorphous layers, preferably at least one n-type doped amorphous layer and at least one p-type doped amorphous layer. Amorphous layers are preferably layers which are less than 50 %, preferably less than 20 %, more preferably less than 10 % crystalline.

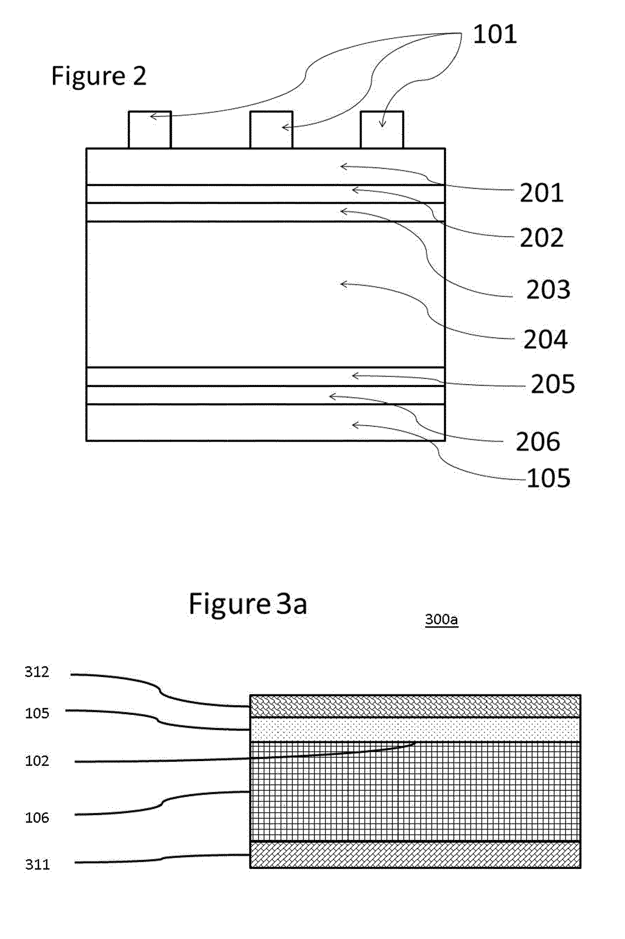

A preferred layer structure according to this embodiment is show in figure 2.

It is known to the person skilled in the art that Si substrates can exhibit a number of shapes, surface textures and sizes. The shape can be one of a number of different shapes including cuboid, disc, wafer and irregular polyhedron amongst others. The preferred shape according to the invention is wafer shaped where that wafer is a cuboid with two dimensions which are similar, preferably equal and a third dimension which is significantly less than the other two dimensions. Significantly less in this context is preferably at least a factor of about 100 smaller.

A variety of surface types are known to the person skilled in the art. According to the invention Si substrates with rough surfaces are preferred. One way to assess the roughness of the substrate is to evaluate the surface roughness parameter for a sub-surface of the substrate which is small in comparison to the total surface area of the substrate, preferably less than about one hundredth of the total surface area, and which is essentially planar. The value of the surface roughness parameter is given by the ratio of the area of the subsurface to the area of a theoretical surface formed by projecting that subsurface onto the flat plane best fitted to the subsurface by minimising mean square displacement. A higher value of the surface roughness parameter indicates a rougher, more irregular surface and a lower value of the surface roughness parameter indicates a smoother, more even surface. According to the invention, the surface roughness of the Si substrate is preferably modified so as to produce an optimum balance between a number of factors including but not limited to light absorption and adhesion of fingers to the surface.

The two larger dimensions of the Si substrate can be varied to suit the application required of the resultant solar cell. It is preferred according to the invention for the thickness of the Si wafer to lie below about 0.5 mm more preferably below about 0.3 mm and most preferably below about 0.2 mm. Some wafers have a minimum size of about 0.01 mm or more.

It is preferred according to the invention for the front doped layer to be thin in comparison to the back doped layer. It is preferred according to the invention for the front doped layer to have a thickness lying in a range from about 0.1 to about 10 µm, preferably in a range from about 0.1 to about 5 µm and most preferably in a range from about 0.1 to about 2 µm.

A highly doped layer can be applied to the back face of the Si substrate between the back doped layer and any further layers. Such a highly doped layer is of the same doping type as the back doped layer and such a layer is commonly denoted with a + (n⁺-type layers are applied to n-type back doped layers and p⁺-type layers are applied to p-type back doped layers). This highly doped back layer serves to assist metallisation and improve electro-conductive properties at the substrate/electrode interface area. It is preferred according to the invention for the highly doped back layer, if present, to have a thickness in a range from about 1 to about 100 µm, preferably in a range from about 1 to about 50 µm and most preferably in a range from about 1 to about 15 µm.

### Dopants

Preferred dopants are those which, when added to the Si wafer, form a p-n junction boundary by introducing electrons or holes into the band structure. It is preferred according to the invention that the identity and concentration of these dopants be specifically selected so as to tune the band structure profile of the p-n junction and set the light absorption and conductivity profiles as required. Preferred p-type dopants according to the invention are those which add holes to the Si wafer band structure. They are well known to the person skilled in the art. All dopants known to the person skilled in the art and which he considers to be suitable in the context of the invention can be employed as p-type dopant. Preferred p-type dopants according to the invention are trivalent elements, particularly those of group 13 of the periodic table. Preferred group 13 elements of the periodic table in this context include but are not limited to B, Al, Ga, In, T1 or a combination of at least two thereof, wherein B is particularly preferred. In one embodiment of the invention, the p-doped layer comprises B as a dopant.

Preferred n-type dopants according to the invention are those which add electrons to the Si wafer band structure. They are well known to the person skilled in the art. All dopants known to the person skilled in the art and which he considers to be suitable in the context of the invention can be employed as n-type dopant. Preferred n-type dopants according to the invention are elements of group 15 of the periodic table. Preferred group 15 elements of the periodic table in this context include N, P, As, Sb, Bi or a combination of at least two thereof, wherein P is particularly preferred. In one embodiment of the invention, the n-doped layer comprises P as dopant.

As described above, the various doping levels of the p-n junction can be varied so as to tune the desired properties of the resulting solar cell.

According to the invention, it is preferred for the back doped layer to be lightly doped, preferably with a dopant concentration in a range from about 1 x 10¹³ to about 1 x 10¹⁸ cm⁻³, preferably in a range from about 1 x 10¹⁴ to about 1 x 10¹⁷ cm⁻³, most preferably in a range from about 5 x 10¹⁵ to about 5 x 10¹⁶ cm⁻³. Some commercial products have a back doped layer with a dopant concentration of about 1 x 10¹⁶.

In one embodiment of the invention, the highly doped back layer (if one is present) is highly doped, preferably with a concentration in a range from about 1 x 10¹⁷ to about 5 x 10²¹ cm⁻³, more preferably in a range from about 5 x 10¹⁷ to about 5 x 10²⁰ cm⁻³, and most preferably in a range from about 1 x 10¹⁸ to about 1 x 10²⁰ cm⁻³.

### Electro-conductive Paste

Preferred electro-conductive pastes according to the invention are pastes which can be applied to a substrate and which, on heating, form solid electrode bodies in physical and/or electrical contact with that substrate. The constituents of the paste and proportions thereof can be selected by the person skilled in the art in order that the paste have the desired properties such as adhesiveness and printability and that the resulting electrode have the desired electrical and physical properties. Metallic particles can be present in the paste, primarily in order that the resulting electrode body be electrically conductive. In order to bring about hardening and adhesion, a polymer system can be employed. An example composition of an electrically-conductive paste which is preferred in the context of the invention might comprise:
i) Metallic particles, preferably silver particles, preferably at least about 50 wt. %, more preferably at least about 70 wt. % and most preferably at least about 80 wt. %;
ii) a polymer system
iii) additives, preferably in a range from about 0.01 to about 22 wt. %, more preferably in a range from about 0.05 to about 15 wt. % and most preferably in a range from about 0.1 to about 10 wt. %;
wherein the first weight loss Δ₃₀, determined according to the test method provided herein, is in the range from about 0.02 to about 0.5, preferably in the range from about 0.03 to about 0.2, more preferably in the range from about 0.05 to about 0.1.

In one embodiment of the invention, the polymer system comprises the following components:
a. a thermoplastic polymer;
b. a solvent system.

In order to facilitate printability of the electro-conductive paste, it is preferred according to the invention that the viscosity of the electro-conductive paste lies in a range from about 5 to about 50 Pa·s, preferably in a range from about 10 to about 40 Pa·s.

It is preferred that the paste be cured at low temperatures, preferably below about 250 °C, more preferably below about 230 °C, most preferably below about 210 °C.

In one embodiment, it is therefore preferred that curing, hardening and adhesion functions is facilitated by a polymer system rather than by an inorganic glass or a glass frit. In one embodiment of the invention, the paste does not contain more than about 1 wt. %, preferably not more than about 0.1 wt. %, more preferably not more than about 0.01 wt. % of an inorganic glass or a glass frit. It is preferred for the paste to contain no such glass.

### Metallic particles

Silver is a preferred metal particle according to the invention. Preferred metallic particles in the context of the invention are those which exhibit metallic conductivity or which yield a substance which exhibits metallic conductivity on firing. Metallic particles present in the electro-conductive paste give metallic conductivity to the solid electrode which is formed when the electro-conductive paste is sintered on firing. Metallic particles which favour effective sintering and yield electrodes with high conductivity and low contact resistance are preferred. Metallic particles are well known to the person skilled in the art. All metallic particles known to the person skilled in the art and which he considers suitable in the context of the invention can be employed as the metallic particles in the electro-conductive paste. Preferred metallic particles according to the invention are metals, alloys, mixtures of at least two metals, mixtures of at least two alloys or mixtures of at least one metal with at least one alloy.

Preferred metals which can be employed as metallic particles, in the same manner as silver, preferably in addition to silver, according to the invention, are Au, Cu, Al, Zn, Pd, Ni, Pb and mixtures of at least two thereof, preferably Au or Al. Preferred alloys which can be employed as metallic particles according to the invention are alloys containing at least one metal selected from the list of Ag, Cu, Al, Zn, Ni, W, Pb, and Pd or mixtures or two or more of those alloys.

In one embodiment of the invention, the metallic particles comprise a metal or alloy coated with one or more further different metals or alloys, for example copper coated with silver.

As additional constituents of the metallic particles, further to above mentioned constituents, those constituents which contribute to more favourable sintering properties, electrical contact, adhesion and electrical conductivity of the formed electrodes are preferred according to the invention. All additional constituents known to the person skilled in the art and which he considers to be suitable in the context of the invention can be employed in the metallic particles. Those additional substituents which represent complementary dopants for the face to which the electro-conductive paste is to be applied are preferred according to the invention. When forming an electrode interfacing with an n-type doped Si layer, additives capable of acting as n-type dopants in Si are preferred. Preferred n-type dopants in this context are group 15 elements or compounds which yield such elements on firing. Preferred group 15 elements in this context according to the invention are P and Bi. When forming an electrode interfacing with a p-type doped Si layer, additives capable of acting as p-type dopants in Si are preferred. Preferred p-type dopants are group 13 elements or compounds which yield such elements on firing. Preferred group 13 elements in this context according to the invention are B and Al.

It is well known to the person skilled in the art that metallic particles can exhibit a variety of shapes, surfaces, sizes, surface area to volume ratios, oxygen content and oxide layers. A large number of shapes are known to the person skilled in the art. Some examples are spherical, angular, elongated (rod or needle like) and flat (sheet like). Metallic particles may also be present as a combination of particles of different shapes. Metallic particles with a shape, or combination of shapes, which favours advantageous sintering, electrical contact, adhesion and electrical conductivity of the produced electrode are preferred according to the invention. One way to characterise such shapes without considering surface nature is through the parameters length, width and thickness. In the context of the invention the length of a particle is given by the length of the longest spatial displacement vector, both endpoints of which are contained within the particle. The width of a particle is given by the length of the longest spatial displacement vector perpendicular to the length vector defined above both endpoints of which are contained within the particle. The thickness of a particle is given by the length of the longest spatial displacement vector perpendicular to both the length vector and the width vector, both defined above, both endpoints of which are contained within the particle. In one embodiment according to the invention, metallic particles with as uniform a shape as possible are preferred i.e. shapes in which the ratios relating the length, the width and the thickness are as close as possible to 1, preferably all ratios lying in a range from about 0.7 to about 1.5, more preferably in a range from about 0.8 to about 1.3 and most preferably in a range from about 0.9 to about 1.2. Examples of preferred shapes for the metallic particles in this embodiment are therefore spheres and cubes, or combinations thereof, or combinations of one or more thereof with other shapes. In one embodiment of the invention, the Ag particles in the electro-conductive paste are spherical. In another embodiment according to the invention, metallic particles are preferred which have a shape of low uniformity, preferably with at least one of the ratios relating the dimensions of length, width and thickness being above about 1.5, more preferably above about 3 and most preferably above about 5. Preferred shapes according to this embodiment are flake shaped, rod or needle shaped, or a combination of flake shaped, rod or needle shaped with other shapes.

A variety of surface types are known to the person skilled in the art. Surface types which favour effective sintering and yield advantageous electrical contact and conductivity of produced electrodes are favoured for the surface type of the metallic particles according to the invention.

The particle diameter d₅₀ and the associated values d₁₀ and d₉₀ are characteristics of particles well known to the person skilled in the art. It is preferred according to the invention that the average particle diameter d₅₀ of the metallic particles lie in a range from about 0.5 to about 10 µm, more preferably in a range from about 1 to about 10 µm and most preferably in a range from about 1 to about 5 µm. The determination of the particle diameter d₅₀ is well known to a person skilled in the art.

In one embodiment of the invention, the silver particles have a d₅₀ in a range from about 0.1 to about 1 µm, preferably in a range from about 0.2 to about 0.9 µm, more preferably in a range from about 0.3 to about 0.8 µm.

The metallic particles may be present with a surface coating. Any such coating known to the person skilled in the art and which he considers to be suitable in the context of the invention can be employed on the metallic particles. Preferred coatings according to the invention are those coatings which promote improved printing, sintering and etching characteristics of the electro-conductive paste. If such a coating is present, it is preferred according to the invention for that coating to correspond to no more than about 10 wt. %, preferably no more than about 8 wt. %, most preferably no more than about 5 wt. %, in each case based on the total weight of the metallic particles.

In one embodiment according to the invention, the silver particles, are present as a proportion of the electro-conductive paste more than about 50 wt. %, preferably more than about 70 wt. %, most preferably more than about 80 wt. %.

### Thermoplastic system

In one embodiment of the invention, the polymer system is a thermoplastic system.

Preferred thermoplastic systems in the context of the invention ensure that the constituents of the electro-conductive paste are present in the form of solutions, emulsions or dispersions and facilitate the formation of a solid electrode on heating. Preferred thermoplastic systems are those which provide optimal stability of constituents within the electro-conductive paste and endow the electro-conductive paste with a viscosity allowing effective line printability.

Preferred thermoplastic systems according to the invention comprise as components:
1. A thermoplastic polymer;
2. A solvent system.

In one embodiment of the invention, it is preferred that the thermoplastic system not exhibit any thermal hysteresis of hardness when heating and cooling to any temperature below the melting temperature of the thermoplastic polymer.

### Thermoplastic polymer

Thermoplastic polymers are well known to the skilled person and he may employ any thermoplastic polymer which he considers suitable for enhancing the favourable properties of the paste or resultant electrode, in particular the curing capability of the paste and the electrical contact between the electrode and the substrate. Preferred thermoplastic polymers show good adhesion on the wafer of the photovoltaic solar cell, are chemically stable under the conditions under which the photovoltaic solar cell is operated in order to guaranty a long operation time of the photovoltaic solar cell, shall not melt at the operation temperatures of the photovoltaic solar cell and should not particular harm the conductivity of the Ag electrode of the photovoltaic solar cell.

Preferred thermoplastic polymers are linear homo- and copolymers. Preferred thermoplastic polymers in the context of the invention are one or more selected from the following list: PVB (polyvinylbutyral); PE (polyethylene); PP (polypropylene), PS (polystyrene); ABS (copolymer of acrylonitrile, butadiene and styrene); PA (polyamide); PC (polycarbonate); polyester, preferably Vitel 2700B from Bostik, Inc.; poly acrylate, preferably Paraloid B44 from Dow Chemical; phenoxy polymer, preferably PKHH from InChem Corp.

### Solvent system

The polymer system preferably comprises a solvent system. The solvent system is preferably able to solve or disperse, more preferably solve, the polymer, preferably the thermoplastic polymer, of the polymer system. In one embodiment, the polymer is a thermoplastic polymer which is solved in the solvent system.

The solvent system is preferably selected in order to achieve the weight losses according to the invention. The solvent system could include one single solvent or two or more solvents. Preferred solvents for achieving the weight loss according to the invention are organic compounds, preferably comprising one or more heteroatoms, preferably one or more selected from the group consisting of: O, S, N, and P, most preferably comprising one or more O atoms.

In one embodiment, the solvent system comprises one or more solvents comprising one or more selected from the group consisting of: one or more heteroatoms, preferably O, singly bonded to two carbon atoms; one or more heteroatoms, preferably O, doubly bonded to one carbon atom; or a combination of both. In one aspect of this embodiment, the solvent system comprises one or more solvents comprising: at least two heteroatoms, preferably O, singly bonded to two carbon atoms; or at least two heteroatoms, preferably O, doubly bonded to one carbon atom; or at least one heteroatoms, preferably O, singly bonded to two carbon atoms and at least one heteroatom, preferably O, doubly bonded to one carbon atom.

In one embodiment, the solvent system comprises one or more solvents comprising one or more selected from the group consisting of: one or more ether groups; one or more ester groups; or a combination of both. In one aspect of this embodiment, the solvent system comprises one or more solvents comprising: two or more ether groups; or two or more ester groups; or one or more ether groups and one or more ester groups.

In one embodiment, the solvent system comprises one or more solvents based on a di-alcohol, or a polyalcohol, preferably comprising: two or more ether groups; two or more ester group; or one or more ether groups and one or more ester groups. Preferred di-alcohols in this context are selected from the group consisting of: ethylene diol, propan-1,2-diol, propan-1,3-diol, butan-1,2-diol, butan-1,3-diol, butan-1,4-diol, butan-2,3-diol, preferably ethylene diol. The preferred polyalcohol in this context is glycerol. In one aspect of this embodiment, the preferred solvent comprises two or more groups selected from the group consisting of: -O-methyl, -O-ethyl, -O-propyl, -O-butyl, -O-pentyl, -O-hexyl, -O(CO)-methyl, -O(CO)-ethyl, -O(CO)-propyl, -O(CO)-butyl, -O(CO)-pentyl, or a combination thereof, preferably with at least one or more preferably at least two being selected from the group consisting of: -O-butyl, and-O(CO)-methyl, or a combination of both. In one aspect of this embodiment, the solvent system comprises one or more solvents selected from the group consisting of: dialkyl ethylene glycol, preferably dibutyl ethylene glycol; or mono alkyl ethylene glycol mono ester, preferably butyl acetyl ethylene glycol; or a combination of both.

It is preferred that the molecular weight of the solvent not exceed 500 g/mol, preferably not exceed 350 g/mol, more preferably not exceed 200 g/mol. It is also preferred that the molecular weight of the polymer system, in particular the thermoplastic polymer system, be greater than the molecular weight of the solvent. More preferably, the molecular weight of the polymer, in particular the thermoplastic polymer is greater than 500 g/mol, preferably greater than 1000 g/mol, more preferably greater than 10,000 g/mol.

### Additives in the electro-conductive paste

Preferred additives in the context of the invention are constituents added to the electro-conductive paste, in addition to the other constituents explicitly mentioned, which contribute to increased performance of the electro-conductive paste, of the electrodes produced thereof or of the resulting solar cell. All additives known to the person skilled in the art and which he considers suitable in the context of the invention can be employed as additive in the electro-conductive paste. In addition to additives present in the vehicle, additives can also be present in the electro-conductive paste. Preferred additives according to the invention are thixotropic agents, viscosity regulators, emulsifiers, stabilising agents or pH regulators, inorganic additives, thickeners and dispersants or a combination of at least two thereof, whereas inorganic additives are most preferred. Preferred inorganic additives in this context according to the invention are Mg, Ni, Te, W, Zn, Mg, Gd, Ce, Zr, Ti, Mn, Sn, Ru, Co, Fe, Cu and Cr or a combination of at least two thereof, preferably Zn, Sb, Mn, Ni, W, Te and Ru or a combination of at least two thereof, oxides thereof, compounds which can generate those metal oxides on firing, or a mixture of at least two of the aforementioned metals, a mixture of at least two of the aforementioned oxides, a mixture of at least two of the aforementioned compounds which can generate those metal oxides on firing, or mixtures of two or more of any of the above mentioned.

### Solar Cell Precursor

A contribution to achieving at least one of the above described objects is made by a solar cell precursor. Preferred solar cell precursors according to the invention comprise the following:
1. a wafer, preferably a silicon wafer, preferably a HIT type wafer,
2. a paste according to the invention;
wherein the paste is located on or over at least one surface of the wafer. The paste may be in physical contact with the silicon wafer or alternatively it may be in contact with the outermost of one or more further layers which are present in between the silicon wafer and the paste, such as a transparent conductive layer or a physically protective layer.

In one embodiment of the invention, one or more further pastes are present on the wafer in addition to the paste according to the invention.

In one embodiment of the invention, the precursor is a precursor to an MWT cell. In this embodiment, a channel connecting the front and back faces of the wafer is preferably present. The paste according to the invention is preferably in contact with the surface of the channel, or on a surface other than the surface or the channel, or both.

In one embodiment of the invention, the solar cell precursor is a precursor to an n-type solar cell. In one aspect of this embodiment, the proportion of the volume of the wafer corresponding to n-doped layers is greater than that corresponding to p-type layers. In another aspect of this embodiment, the front face, sometimes called the sunny side, of the wafer is p-type doped. In another aspect of this embodiment the back face of the wafer is n-type doped.

In one embodiment of the invention, the solar cell precursor is a precursor to a p-type solar cell. In one aspect of this embodiment, the proportion of the volume of the wafer corresponding to p-doped layers is greater than that corresponding to n-type layers. In another aspect of this embodiment, the front face, sometimes called the sunny side, of the wafer is n-type doped. In another aspect of this embodiment the back face of the wafer is p-type doped.

HIT type solar cell precursors are preferred in the context of the invention. In one aspect of this embodiment, the wafer comprises at least one layer of amorphous Si. Preferably, at least one layer of amorphous Si is n-type doped. Preferably, at least one layer of amorphous Si is p-type doped. Preferably at least one or more than one, preferably two, layers of amorphous Si are intrinsic (non-doped). Preferably, the wafer comprises at least one crystalline layer, preferably n-type doped or p-type doped, preferably n-type doped.

In the preparation of the solar cell precursor, it is preferred for the temperature to be maintained low, preferably below 100 °C, more preferably below about 80 °C, most preferably below about 60 °C.

### Process for producing a Solar Cell

A contribution to achieving at one of the aforementioned objects is made by a process for producing a solar cell at least comprising the following as process steps:
i) provision of a solar cell precursor as described above, in particular combining any of the above described embodiments; and
ii) heating of the solar cell precursor to obtain a solar cell.

It is preferred that the temperature in step i) not exceed 100 °C, preferably 80 °C, preferably 60 °C.

### Printing

It is preferred according to the invention that each of the electrodes be provided by applying an electro-conductive paste and then heating that electro-conductive paste to obtain an adhered body. The electro-conductive paste can be applied in any manner known to the person skilled in that art and which he considers suitable in the context of the invention including but not limited to impregnation, dipping, pouring, dripping on, injection, spraying, knife coating, curtain coating, brushing or printing or a combination of at least two thereof, wherein preferred printing techniques are ink-jet printing, screen printing, tampon printing, offset printing, relief printing or stencil printing or a combination of at least two thereof. It is preferred according to the invention that the electro-conductive paste is applied by printing, preferably by screen printing. It is preferred according to the invention that the screens have mesh opening with a diameter in a range from about 20 to about 100 µm, more preferably in a range from about 30 to about 80 µm, and most preferably in a range from about 40 to about 70 µm. As detailed in the solar cell precursor section, it is preferred for the electro-conductive paste applied to the channel to be as described in this invention. The electro-conductive pastes used to form the front and back electrodes can be the same or different to the paste used in the channel, preferably different, and can be the same as or different to each other.

It is preferred for printing not to be carried out at a high temperature, preferably below 100 °C, more preferably below about 80 °C, more preferably below about 50 °C.

### Heating

It is preferred according to the invention for electrodes to be formed by first applying an electro-conductive paste and then heating said electro-conductive paste to yield a solid electrode body. Heating is well known to the person skilled in the art and can be effected in any manner known to him and which he considers suitable in the context of the invention.

According to the invention, the maximum temperature set for the heating is below about 250 °C, preferably below about 230 °C, more preferably below about 210 °C. Heating temperatures as low as about 100 °C have been employed for obtaining solar cells.

Heating of electro-conductive pastes on the front face and back face can be carried out simultaneously or sequentially. Simultaneous heating is appropriate if the electro-conductive pastes have similar, preferably identical, optimum heating conditions. Where appropriate, it is preferred according to the invention for heating to be carried out simultaneously.

### Solar Cell

A contribution to achieving at least one of the above described objects is made by a solar cell obtainable by a process according to the invention. Preferred solar cells according to the invention are those which have a high efficiency in terms of proportion of total energy of incident light converted into electrical energy output and which are light and durable.

### Anti-reflection Coating

According to the invention, an anti-reflection coating can be applied as the outer and often as the outermost layer before the electrode on the front face of the solar cell. Preferred anti-reflection coatings according to the invention are those which decrease the proportion of incident light reflected by the front face and increase the proportion of incident light crossing the front face to be absorbed by the wafer. Anti-reflection coatings which give rise to a favourable absorption/reflection ratio, are susceptible to etching by the employed electro-conductive paste but are otherwise resistant to the temperatures required for heating of the electro-conductive paste, and do not contribute to increased recombination of electrons and holes in the vicinity of the electrode interface are favoured. All anti-reflection coatings known to the person skilled in the art and which he considers to be suitable in the context of the invention can be employed. Preferred anti-reflection coatings according to the invention are SiNₓ, SiO₂, Al₂O₃, TiO₂ or mixtures of at least two thereof and/or combinations of at least two layers thereof, wherein SiNₓ is particularly preferred, in particular where an Si wafer is employed. In particular for HIT cells metal oxides can serve as an anti-reflection coating. Preferred oxides are indium tin oxide (ITO), fluorine doped tin oxide (FTO) or doped zinc oxide, preferably indium tin oxide.

The thickness of anti-reflection coatings is suited to the wavelength of the appropriate light. According to the invention it is preferred for anti-reflection coatings to have a thickness in a range from about 30 to about 500 nm, more preferably in a range from about 50 to about 400 nm and most preferably in a range from about 80 to about 300 nm.

### Passivation Layers

According to the invention, one or more passivation layers can be applied to the front and/or back side as outer or as the outermost layer before the electrode, or before the anti-reflection layer if one is present. Preferred passivation layers are those which reduce the rate of electron/hole recombination in the vicinity of the electrode interface. Any passivation layer which is known to the person skilled in the art and which he considers to be suitable in the context of the invention can be employed. Preferred passivation layers according to the invention are silicon nitride, silicon dioxide and titanium dioxide, silicon nitride being most preferred. According to the invention, it is preferred for the passivation layer to have a thickness in a range from about 0.1 nm to about 2 µm, more preferably in a range from about 1 nm to about 1 µm and most preferably in a range from about 5 nm to about 200 nm. It is preferred for HIT cells that an intrinsic Si layer functions as a passivation layer. The function of an anti-reflection coating and a passivation layer can be at least partly or completely combined in one layer.

### Transparent conductive layer

Preferred transparent conductive layers in the context of the invention are layers on or over the silicon wafer which have a high transparency and conductivity. The transmission of light with a wavelength of 400 nm through the layer is preferably above about 50 %, more preferably above about 80 %, most preferably above about 90 %. The electrical conductivity of the layer is preferably above about 1*10⁻⁴ Ω⁻¹ cm⁻¹, more preferably above about 5*10⁻³ Ω⁻¹ cm⁻¹, most preferably above about 5*10⁻² Ω⁻¹ cm⁻¹.

The thickness of the transparent conductive layer is preferably in the range from about 30 to about 500 nm, more preferably in the range from about 50 to about 400 nm, most preferably in the range from about 80 to about 300 nm.

Transparent conductive materials are well known to the skilled person and he may select the material in order to improve the advantageous properties of the solar cell, such as conductivity, transparency and adhesion. Preferred materials are oxides, conductive polymers or carbon nano-tube based conductors, preferably oxides. Preferred oxides are indium tin oxide (ITO), fluorine doped tin oxide (FTO) or doped zinc oxide, preferably indium tin oxide. Preferred conductive polymers are organic compounds with conjugated double bonds, preferably polyacetylenes, polyanilines, polypyrroles or polythiophenes or derivatives thereof, or combinations thereof.

In one embodiment, the solar cell has a transparent conductive layer on the front face.

### Additional Protective layers

In addition to the layers described above which directly contribute to the principle function of the solar cell, further layers can be added for mechanical and chemical protection. The cell can be encapsulated to provide chemical protection. Encapsulations are well known to the person skilled in the art and any encapsulation can be employed which is known to him and which he considers suitable in the context of the invention. According to the invention, transparent polymers, often referred to as transparent thermoplastic resins, are preferred as the encapsulation material, if such an encapsulation is present. Preferred transparent polymers in this context are for example silicon rubber and polyethylene vinyl acetate (PVA).

A transparent glass sheet can be added to the front of the solar cell to provide mechanical protection to the front face of the cell. Transparent glass sheets are well known to the person skilled in the art and any transparent glass sheet known to him and which he considers to be suitable in the context of the invention can be employed as protection on the front face of the solar cell.

A back protecting material can be added to the back face of the solar cell to provide mechanical protection. Back protecting materials are well known to the person skilled in the art and any back protecting material which is known to the person skilled in the art and which he considers to be suitable in the context of the invention can be employed as protection on the back face of the solar cell. Preferred back protecting materials according to the invention are those having good mechanical properties and weather resistance. The preferred back protection materials according to the invention is polyethylene terephthalate with a layer of polyvinyl fluoride. It is preferred according to the invention for the back protecting material to be present underneath the encapsulation layer (in the event that both a back protection layer and encapsulation are present).

A frame material can be added to the outside of the solar cell to give mechanical support. Frame materials are well known to the person skilled in the art and any frame material known to the person skilled in the art and which he considers suitable in the context of the invention can be employed as frame material. The preferred frame material according to the invention is aluminium.

### Solar panels

A contribution to achieving at least one of the above mentioned objects is made by a module comprising at least a solar cell obtained as described above, in particular according to at least one of the above described embodiments, and at least one more solar cell. A multiplicity of solar cells according to the invention can be arranged spatially and electrically connected to form a collective arrangement called a module. Preferred modules according to the invention can take a number of forms, preferably a rectangular surface known as a solar panel. A large variety of ways to electrically connect solar cells as well as a large variety of ways to mechanically arrange and fix such cells to form collective arrangements are well known to the person skilled in the art and any such methods known to him and which he considers suitable in the context of the invention can be employed. Preferred methods according to the invention are those which result in a low mass to power output ratio, low volume to power output ration, and high durability. Aluminium is the preferred material for mechanical fixing of solar cells according to the invention.

### DESCRIPTION OF THE DRAWINGS

The invention is now explained by means of figures which are intended for illustration only and are not to be considered as limiting the scope of the invention. In brief,
Fig. 1a shows a cross sectional view of a common n-type layer configuration for a solar cell,
Fig. 1b shows a cross sectional view of a common p-type layer configuration for a solar cell,
Fig. 2 shows a cross sectional view of a common HIT-type layer configuration for a solar cell,
Fig. 3a, 3b and 3c together illustrate the process of firing a front side paste,
Fig. 4 shows representative heating profiles for the weight loss test methods

Figure 1a shows a cross sectional view of a common n-type layer configuration for a solar cell. Starting from the front side, 101 are electrodes, preferably in the form of fingers, preferably obtained from a paste according to the invention by a method according to the invention. 102 is one or more optional layers, such as an anti-reflection layer or a passivation layer. 103 is a p-doped from layer, preferably an Si layer. 104 is an n-doped back layer, preferably an Si layer. 105 is the back electrode, preferably obtained from a paste according to the invention by a method according to the invention.

Figure 1b shows a cross sectional view of a common p-type layer configuration for a solar cell. Starting from the front side, 101 are electrodes, preferably in the form of fingers, preferably obtained from a paste according to the invention by a method according to the invention. 102 is one or more optional layers, such as an anti-reflection layer or a passivation layer. 104 is an n-doped from layer, preferably an Si layer. 103 is a p-doped back layer, preferably an Si layer. 105 is the back electrode, preferably obtained from a paste according to the invention by a method according to the invention.

Figure 2 shows a cross sectional view of a common HIT type layer configuration for a solar cell. 101 are electrodes, preferably in the form of fingers, preferably obtained from a paste according to the invention by a method according to the invention. 201 is one or more optional layers, preferably comprising a transparent conductive layer, such as indium tin oxide. 202 is an amorphous front layer, preferably an Si layer, of a first doping type, n-type or p-type, preferably p-type. 203 is an intrinsic (non-doped) amorphous front layer, preferably an Si layer. 204 is crystalline layer, preferably an Si layer, preferably n-type doped. 205 is an intrinsic (non-doped) amorphous back layer. 206 is an amorphous front layer, preferably an Si layer, or the opposite doping type to the first doping type, preferably n-type doped. 105 is the back electrode, preferably obtained from a paste according to the invention by a method according to the invention.

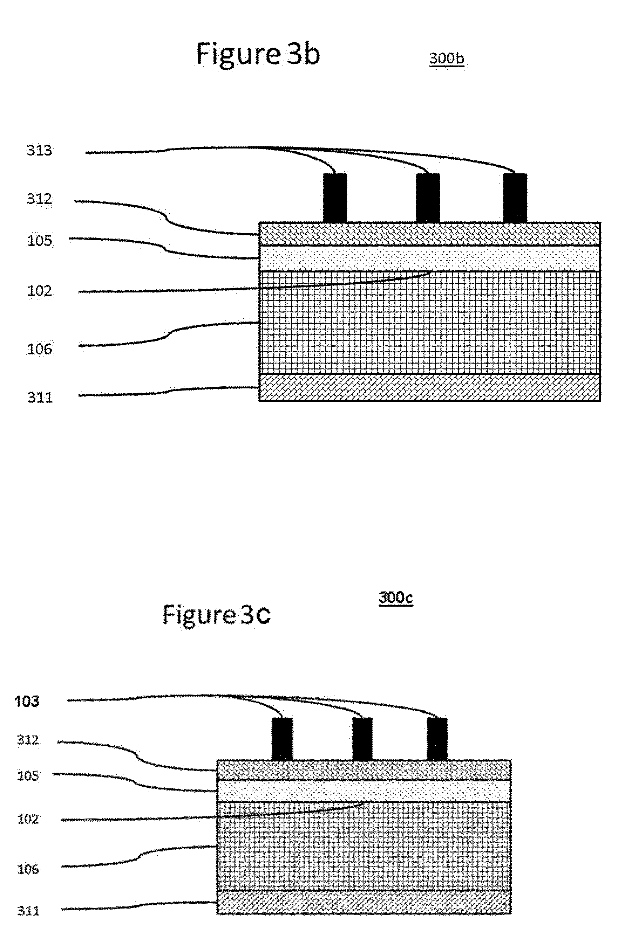

Figures 3a, 3b and 3c together illustrate the process of firing a front side paste to yield a front side electrode. Figures 3a, 3b and 3c are schematic and generalised and additional layers further to those constituting the p-n junction are considered simply as optional additional layers without more detailed consideration.

Figure 3a illustrates a wafer before application of front electrode, 300a. Starting from the back face and continuing towards the front face the wafer before application of front electrode 300a optionally comprises additional layers on the back face 311, a back doped layer 106, a p-n junction boundary 102, a front doped layer 105 and additional layers on the front face 312. The additional layers on the back face 311 can comprise any of a back electrode, a back passivation layer, a highly doped back layer or none of the above. The additional layer on the front face 312 can comprise any of a front passivation layer, an anti-reflection layer or none of the above.

Figure 3b shows a wafer with electro-conductive paste applied to the front face before firing 300b. In addition to the layers present in 300a described above, an electro-conductive paste 313 is present on the surface of the front face.

Figure 3c shows a wafer with front electrode applied 300c. In addition to the layers present in 300a described above, a front side electrode 103 is present which is formed from the electro-conductive paste 313 of figure 3b by firing.

In figures 3b and 3c, the applied electro-conductive paste 313 and the front electrodes 103 are shown schematically as being present as three bodies. This is purely a schematic way of representing a non-complete coverage of the front face by the paste/electrodes and the invention does not limit the paste/electrodes to being present as three bodies.

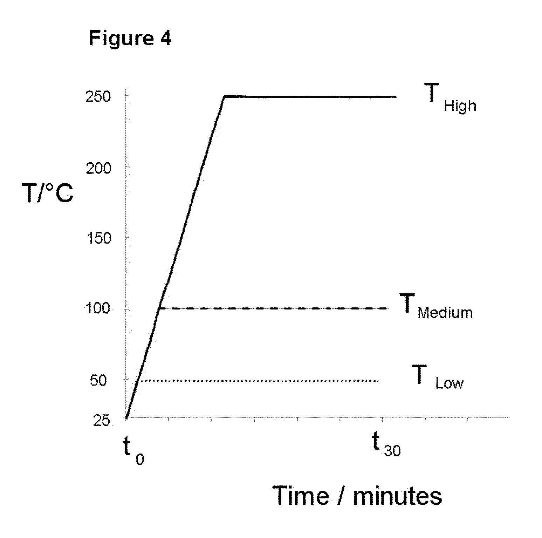

Figure 4 shows the heating profiles according to the weight loss test methods below. The heating profile T_{medium} used for the measurement of Δ₃₀ is shown by the dashed line. The temperature T_{medium} increases at a rate of 10K/minute from 25 °C at time to = 0 to 100 °C and is maintained at 100 °C until time t₃₀ = 30 minutes. Δ₃₀ is the weight loss over this period t₀ to t₃₀ expressed as a wt. % based on the weight of the paste as measured at t₀. The heating profile Thigh used for the measurement of Δ_{high 30} is shown by the solid line. The temperature Thigh increases at a rate of 10K/minute from 25 °C at time to = 0 to 250 °C and is maintained at 250 °C until time t₃₀ = 30 minutes. Δ high ₃₀ is the weight loss over this period t₀ to t₃₀ expressed as a wt. % based on the weight of the paste as measured at t₀. The heating profile T_{low} used for the measurement of Δ_{low 30} is shown by the dotted line. The temperature T_{low} increases at a rate of 10K/minute from 25 °C at time to = 0 to 50 °C and is maintained at 50 °C until time t₃₀ = 30 minutes. Δ_{low 30} is the weight loss over this period t₀ to t₃₀ expressed as a wt. % based on the weight of the paste as measured at to. In practice, the equilibration to the isotherm at the holding temperature may not be as sharp as indicated in the figure. Any variations from the temperature profile shown in the figure must not exceed 10 K at any time and the isotherm, characterised by variations not exceeding 0.5 K from the isotherm, must be attained within 5 minutes of reaching the holding temperature. An appropriate measuring device should provide heating profiles obeying the above.

### TEST METHODS

The following test methods are used in the invention. In absence of a test method, the ISO test method for the feature to be measured being closest to the earliest filing date of the present application applies. In absence of distinct measuring conditions, standard ambient temperature and pressure (SATP) (temperature of 298.15 K and an absolute pressure of 100 kPa) apply.

### Determination of maximum weight loss

A portion of the paste is printing on a glass substrate using a stencil with a 2 cm by 2 cm square open area and a stencil thickness of 100 µm. The weight of the paste sample is determined with a scale. The paste sample is placed in a convection oven at a temperature of 100 °C for 12 h in order to remove the volatile parts at this temperature. After the drying step the weight of the sample is determined again and the maximum weight loss is calculated as the difference between the paste weight before and after the drying step, expressed as a wt. % based on the total weight of the paste measured before the drying step.

### First weight loss Δ₃₀

The first weight loss Δ₃₀ of the paste is determined using a STA apparatus Netzsch STA 449 F3 Jupiter (Netzsch) equipped with a sample holder HTP 40000A69.010, thermocouple Type S and a platinum oven Pt S TC:S (all from Netzsch). For the measurements and data evaluation the measurement software Netzsch Messung V5.2.1 and Proteus Thermal Analysis V5.2.1 are applied. As pan for reference and sample, aluminium oxide pan GB 399972 and cap GB 399973 (both from Netzsch) with a diameter of 6.8 mm and a volume of about 85 µl are used. An amount of about 40-60 mg of the sample is weighed into the sample pan with an accuracy of 0.01 mg. The empty reference pan and the sample pan are placed in the apparatus, the oven is closed and the measurement started. As detailed in the figures section above, the sample is heated at a rate of 10K/min, starting at 25 °C at time to = 0, up to 100 °C. The temperature is then held at 100 °C until a time t₃₀ = 30 minutes as measured from the start of heating to. Δ₃₀ is the loss in weight of the paste between the times t₀ and t_{30,} expressed as a wt. % based on the total weight of the paste measured at t₀, divided by the maximum weight loss for the paste as determined above.

### Second weight loss ratio Δ_{low 30}

The second weight loss Δ_{low 30} of the paste is determined using a STA apparatus Netzsch STA 449 F3 Jupiter (Netzsch) equipped with a sample holder HTP 40000A69.010, thermocouple Type S and a platinum oven Pt S TC:S (all from Netzsch). For the measurements and data evaluation the measurement software Netzsch Messung V5.2.1 and Proteus Thermal Analysis V5.2.1 are applied. As pan for reference and sample, aluminium oxide pan GB 399972 and cap GB 399973 (both from Netzsch) with a diameter of 6.8 mm and a volume of about 85 µl are used. An amount of about 40-60 mg of the sample is weighed into the sample pan with an accuracy of 0.01 mg. The empty reference pan and the sample pan are placed in the apparatus, the oven is closed and the measurement started. As detailed in the figures section above, the sample is heated at a rate of 10K/min, starting at 25 °C at time to = 0, up to 50 °C. The temperature is then held at 50 °C until a time t₃₀ = 30 minutes as measured from the start of heating to. Δ_{low 30} is the loss in weight of the paste between the times t₀ and t_{30,} expressed as a wt. % based on the total weight of the paste measured at to, divided by the maximum weight loss for the paste as determined above.

### Third weight loss ratio Δ_{high 30}

The third weight loss Δ_{high 30} of the paste is determined using a STA apparatus Netzsch STA 449 F3 Jupiter (Netzsch) equipped with a sample holder HTP 40000A69.010, thermocouple Type S and a platinum oven Pt S TC:S (all from Netzsch). For the measurements and data evaluation the measurement software Netzsch Messung V5.2.1 and Proteus Thermal Analysis V5.2.1 are applied. As pan for reference and sample, aluminium oxide pan GB 399972 and cap GB 399973 (both from Netzsch) with a diameter of 6.8 mm and a volume of about 85 µl are used. An amount of about 40-60 mg of the sample is weighed into the sample pan with an accuracy of 0.01 mg. The empty reference pan and the sample pan are placed in the apparatus, the oven is closed and the measurement started. As detailed in the figures section above, the sample is heated at a rate of 10K/min, starting at 25 °C at time to = 0, up to 250 °C. The temperature is then held at 250 °C until a time t₃₀ = 30 minutes as measured from the start of heating t₀. Δ_{high 30} is the loss in weight of the paste between the times t₀ and t₃₀, expressed as a wt. % based on the total weight of the paste measured at to, divided by the maximum weight loss for the paste as determined above.

### Viscosity

Viscosity measurements were performed using the Thermo Fischer Scientific Corp. "Haake Rheostress 600" equipped with a ground plate MPC60 Ti and a cone plate C 20/0,5° Ti and software "Haake RheoWin Job Manager 4.30.0". After setting the distance zero point, a paste sample sufficient for the measurement was placed on the ground plate. The cone was moved into the measurement positions with a gap distance of 0.026 mm and excess material was removed using a spatula. The sample was equilibrated to 25 °C for three minutes and the rotational measurement started. The shear rate was increased from 0 to 20 s⁻¹ within 48 s and 50 equidistant measuring points and further increased to 150 s⁻¹ within 312 s and 156 equidistant measuring points. After a waiting time of 60 s at a shear rate of 150 s⁻¹, the shear rate was reduced from 150 s⁻¹ to 20 s⁻¹ within 312 s and 156 equidistant measuring points and further reduced to 0 within 48 s and 50 equidistant measuring points. The micro torque correction, micro stress control and mass inertia correction were activated. The viscosity is given as the measured value at a shear rate of 100 s⁻¹ of the downward shear ramp.

### Specific Surface Area

BET measurements to determine the specific surface area of particles are made in accordance with DIN ISO 9277:1995. A Gemini 2360 (from Micromeritics) which works according to the SMART method (Sorption Method with Adaptive dosing Rate), is used for the measurement. As reference material Alpha Aluminum oxide CRM BAM-PM-102 available from BAM (Bundesanstalt für Materialforschung und -prüfung) is used. Filler rods are added to the reference and sample cuvettes in order to reduce the dead volume. The cuvettes are mounted on the BET apparatus. The saturation vapour pressure of nitrogen gas (N₂ 5.0) is determined. A sample is weighed into a glass cuvette in such an amount that the cuvette with the filler rods is completely filled and a minimum of dead volume is created. The sample is kept at 80°C for 2 hours in order to dry it. After cooling the weight of the sample is recorded. The glass cuvette containing the sample is mounted on the measuring apparatus. To degas the sample, it is evacuated at a pumping speed selected so that no material is sucked into the pump. The mass of the sample after degassing is used for the calculation. The dead volume is determined using Helium gas (He 4.6). The glass cuvettes are cooled to 77 K using a liquid nitrogen bath. For the adsorptive, N₂ 5.0 with a molecular cross-sectional area of 0.162 nm² at 77 K is used for the calculation. A multi-point analysis with 5 measuring points is performed and the resulting specific surface area given in m²/g.

### Ag Particles Size Determination (d₁₀, d₅₀, d₉₀)

Particle size determination for Ag particles is performed in accordance with ISO 13317-3:2001. A Sedigraph 5100 with software Win 5100 V2.03.01 (from Micromeritics) which works according to X-ray gravitational technique is used for the measurement. A sample of about 400 to 600 mg is weighed into a 50 ml glass beaker and 40 ml of Sedisperse PI (from Micromeritics, with a density of about 0.74 to 0.76 g/cm³ and a viscosity of about 1.25 to 1.9 mPa*s) are added as suspending liquid. A magnetic stirring bar is added to the suspension. The sample is dispersed using an ultrasonic probe Sonifer 250 (from Branson) operated at power level 2 for 8 minutes while the suspension is stirred with the stirring bar at the same time. This pre-treated sample is placed in the instrument and the measurement started. The temperature of the suspension is recorded (typical range 24 °C to 45 °C) and for calculation data of measured viscosity for the dispersing solution at this temperature are used. Using density and weight of the sample (density 10.5 g/cm³ for silver) the particle size distribution is determined and given as d₅₀, d₁₀ and d₉₀.

### Dopant Level

Dopant levels are measured using secondary ion mass spectroscopy.

### Efficiency, Fill Factor, Open Circuit Voltage, Contact Resistance, Short Circuit Current Density and Series Resistance

The sample solar cell is characterized using a commercial IV-tester "cetisPV-CTL1" from Halm Elektronik GmbH. All parts of the measurement equipment as well as the solar cell to be tested were maintained at 25 °C during electrical measurement. This temperature is always measured simultaneously on the cell surface during the actual measurement by a temperature probe. The Xe Arc lamp simulates the sunlight with a known AM1.5 intensity of 1000 W/m² on the cell surface. To bring the simulator to this intensity, the lamp is flashed several times within a short period of time until it reaches a stable level monitored by the "PVCTControl 4.313.0" software of the IV-tester. The Halm IV tester uses a multi-point contact method to measure current (I) and voltage (V) to determine the cell's IV-curve. To do so, the solar cell is placed between the multi-point contact probes in such a way that the probe fingers are in contact with the bus bars of the cell. The numbers of contact probe lines are adjusted to the number of bus bars on the cell surface. All electrical values were determined directly from this curve automatically by the implemented software package. As a reference standard a calibrated solar cell from ISE Freiburg consisting of the same area dimensions, same wafer material and processed using the same front side layout is tested and the data compared to the certificated values. At least 5 wafers processed in the very same way are measured and the data interpreted by calculating the average of each value. The software PVCTControl 4.313.0 provides values for efficiency, fill factor, short circuit current density J_{sc}, series resistance and open circuit voltage.

### Molecular weight

The molecular weight of the thermoplastic polymers is determined by GPC (Gel Permeation Chromatography) followed by light scattering. For the various thermoplastic polymers GPC conditions such as selection of appropriate columns, eluent, pressure and temperature the DIN procedure valid for the particular thermoplastic polymer on August 29, 2012 shall be applied. If not indicated to the contrary in the DIN procedures, SECcurity on-line multi angle light scattering detector SLD7000(B) commercially available from PSS Polymer Standards Service GmbH shall be used for determination of the molecular weight by light scattering.

### EXAMPLES

The invention is now explained by means of examples which are intended for illustration only and are not to be considered as limiting the scope of the invention.

### Example 1 - paste preparation

By means of a Kenwood Major Titanium mixer a paste was made by homogenizing the appropriate amounts of the ingredients for the thermoplastic polymer system (Table 1) and a spherical Ag powder 1 (Silver Powder 7000-35 from former Ferro Material Systems; now Ames Goldsmith Corporation.) with a peak maxima according to the above test method of 0.45 µm). The paste was passed through a 3-roll mill Exact 80 E with stainless steel rolls with a first gap of 120 µm and a second gap of 60 µm with progressively decreasing gaps to 20 µm for the first gap and 10 µm for the second gap several times until homogeneity.

**Table 1 - Constitution of polymer system**

| Component | 1 (inventive) | 2 (comparative) | 3 (comparative) |
|---|---|---|---|
| Cyclohexanone | 0 | 63.36 | 0 |
| Butyl diglycol acetate | 67.47 | 15.41 | 0 |
| Butyl diglycol | 11.30 | | 10.00 |
| Diethylsebacate | 0 | 0 | 68.77 |
| Vitel 2700B (from Bostik, Inc.) | 21.23 | 21.23 | 21.23 |

**Table 2 - Paste Constitution**

| Ag powder [wt. %] | | polymer system [wt. %] |
|---|---|---|
| 85.87 | | 14.13 |

### Example 2 - Solar Cell Preparation and Measurement of Cell Properties

Pastes were applied to mono-crystalline HIT solar cell precursor, available from Roth & Rau AG. The wafers had dimensions of about 156 x 156 mm². The solar cells used were textured by alkaline etching and had an ITO (indium-tin-oxide) layer on the surface. The example paste was screen-printed onto the texturized ITO-layer using a semi-automatic screen printer X1 SL from Asys Group, EKRA Automatisierungssysteme set with the following screen parameters: 290 mesh, 20 µm wire thickness, 18 µm emulsion over mesh, 72 fingers, 60 µm finger opening, 3 bus bars, 1.5 mm bus bar width. The device with the printed patterns was cured for 10 minutes at 200 °C in an oven after printing.

**Table 3 - weight loss**

| Example | Δ₃₀/wt. % | Δ_{low 30} / wt. % | Δ_{high 30} / wt. % |
|---|---|---|---|
| 1 (Inventive) | 0.056 | 0.0071 | 0.99 |
| 2 (comparative) | 0.73 | 0.36 | 0.99 |
| 3 (comparative) | 0.014 | 0.0025 | 0.81 |

**Table 4 -printing and solar cells properties.**

| Example | Effective printing period | J_{sc} [mA/cm²] |
|---|---|---|
| 1 (Inventive) | + | + |
| 2 (Comparative) | -- | ++ |
| 3 (Comparative) | ++ | - |

| | | |
|---|---|---|
| Results displayed as --: very unfavourable, -: unfavourable, o: moderate, +: favourable | | |

### REFERENCE LIST

- 101: Front electrodes
- 102: Optional front layers
- 103: p-type doped layer
- 104: n-type doped layer
- 105: Back electrode
- 201: Optional front layers, such as indium tin oxide
- 202: Front doped amorphous layer
- 203: Front intrinsic amorphous layer
- 204: Crystalline layer
- 205: Back intrinsic amorphous layer
- 206: Back doped amorphous layer
- 300: Wafer
- 311: Additional layers on back face
- 312: Additional layers on front face
- 313: Electro-conductive paste
- 214: Front electrode fingers
- 215: Front electrode bus bars

## Claims

1. A paste comprising the following paste constituents:
a. Metal particles;
b. A polymer system;
wherein the first weight loss Δ₃₀, determined according to the test method provided herein, is in the range from about 0.02 to about 0.5.

2. The paste according to claim 1, wherein the second weight loss Δ_{low 30}, determined according to the test method provided herein, is in the range from about 0.001 to about 0.1.

3. The paste according to any of the preceding claims, wherein the third weight loss Δ high ₃₀, determined according to the test method provided herein, is in the range from about 0.3 to about 1.

4. The paste according to any of the preceding claims, wherein the metallic particles are silver.

5. The paste according to any of the preceding claims, wherein the metallic particles are at least about 70 wt. %, based on the total weight of the paste.

6. The paste according to any of the preceding claims, wherein the polymer system is a thermoplastic polymer system, wherein the thermoplastic polymer system comprises a thermoplastic polymer.

7. The paste according to claim 6, wherein the thermoplastic polymer is present in the thermoplastic polymer system in an amount in the range from about 5 to about 45 wt. %, based on the total weight of the thermoplastic polymer system.

8. The paste according to claim 6 or 7, wherein the thermoplastic polymer is selected from the group consisting of a polyester, an acrylate polymer, a phenoxy polymer.

9. A precursor comprising the following precursor components:
a. a substrate;
b. a paste according to any of the preceding claims superimposed on the substrate.

10. A precursor according to claim 9, wherein the substrate is a silicon wafer.

11. The precursor according to claim 9 or 10, wherein the wafer comprises a first silicon layer, wherein less than 50 wt. % of the first silicon layer is crystalline.

12. A process for the preparation of an electrical or electronic component comprising the following preparation steps:
a. providing a precursor according to any of the claims 9 to 11;
b. heating the precursor to obtain the component.

13. The process according to claim 12, wherein the component is a solar cell.

14. The process according to claim 12 or 13, wherein the maximum firing temperature in step ii is in the range from about 50 to about 300 °C.

15. A solar cell obtainable by the process according to any of the claims 12 to 14.

16. A module comprising at least 2 solar cells, at least 1 of which is according to claim 15.
